# EUROPEAN PATENT SPECIFICATION

(11) **EP 3 646 038 B1**
(45) Date of publication and mention of the grant of the patent: **07.08.2024**
(21) Application number: 18735524.3
(22) Date of filing: 21.06.2018
(51) Int. Cl.: G01R 19/00

(54) **CURRENT SENSING CIRCUIT AND INTEGRATED CIRCUIT**
STROMMESSSCHALTUNG UND INTEGRIERTE SCHALTUNG
CIRCUIT DE DÉTECTION DE COURANT ET CIRCUIT INTÉGRÉ

(30) Priority: 28.06.2017 CN 201720762779 U
(43) Date of publication of application: 06.05.2020
(73) Proprietor: Robert Bosch GmbH, 70442 Stuttgart (DE)
(72) Inventor: ZHENG, Zhong, Shanghai 200335 (CN); JING, Na, Shanghai 200335 (CN); OUYANG, Yi, Shanghai 200335 (CN); XU, Xaiowen, Shanghai 200335 (CN)
(86) International application number: PCT/EP2018/066558
(87) International publication number: WO 2019/002083

(56) References cited:
- US-A- 5 008 586
- US-A- 5 585 746
- US-A1- 2006 255 774
- US-A1- 2013 235 487
- US-A1- 2014 269 834
- US-A1- 2014 285 178
- US-B1- 6 384 636

## Description

### Technical Field

The present disclosure relates to the field of current sensing, in particular to a current sensing circuit and an integrated circuit.

### Background Art

A vehicle typically comprises a port fuel injection (PFI) valve needle for controlling the fuel injection of the vehicle's engine. A PFI valve needle has a metal-oxide-semiconductor field-effect transistor (MOSFET). By changing the control signal provided by the field-effect transistor of the PFI valve needle, the operating current flowing through the field-effect transistor can be changed so that the opening degree of the PFI valve needle can be adjusted, thereby allowing control of the fuel injection amount of the vehicle's engine.

In order to accurately control the fuel injection amount of an engine, it is necessary to know the operating current flowing through the field-effect transistor of the PFI valve needle. The current method is to use a current sensing circuit having a field-effect transistor (hereinafter referred to as the sensing field-effect transistor) to sense the operating current of a field-effect transistor flowing through a PFI valve needle (hereinafter referred to as the working field-effect transistor). The sensing field-effect transistor generates a sensing current that is proportional to the operating current flowing through the working field-effect transistor, wherein the ratio of the sensing current to the operating current is referred to as the current mirror ratio. The resistance Rdson between the drain and the source of the sensing field-effect transistor during conduction is much larger than the resistance Rdson of the working field-effect transistor, so that the current sensing does not affect the operating current flowing through the working field-effect transistor.

The resistance Rdson of the working field-effect transistor and the sensing field-effect transistor has a characteristic of temperature dependence, which influences the current mirror ratio. For this reason, an operational amplifier is added to the current sensing circuit to eliminate the influence of temperature dependence of the resistance Rdson of field-effect transistors on the current mirror ratio. However, when the operating current of the working field-effect transistor is small, the input offset of the operational amplifier will affect the current sensing.

Some techniques have been developed for reducing the input offset of an operational amplifier, but these techniques increase the complexity and the cost of the circuit.

US 6 384 636 B1 provides a current-sense circuit with a fast and precise measure of current through a switch with the sensing circuit being protected from a high-voltage across the switch and from large transient currents through the switch when the switch is first closed. The sensed load current is connected through a first conductive path including the current switch and through a second conductive path for passing a scaled portion of the current and a scaled bias current.

US 2013/0235487 A1 provides amplifier architecture for current sensing application. An amplifier includes a load device, an operational amplifier, a current source, and a bipolar transistor. The operational amplifier has a first input terminal connected to a first input node that receives an input current, and a second input terminal connected to a second input node that receives a reference voltage.

### Summary

Embodiments of the present disclosure provide current sensing circuits and integrated circuits that can reduce the input offset of an operational amplifier without increasing the complexity or the cost of the circuit.

A current sensing circuit according to the present invention is provided as defined by independent claim 1. The current sensing circuit comprises: a second field-effect transistor for generating a sensing current proportional to a current flowing through a working circuit having a first field-effect transistor; a first bipolar transistor and a second bipolar transistor having bases connected together, wherein the emitter of the first bipolar transistor and the emitter of the second bipolar transistor are respectively connected to the drain of the first field-effect transistor and the drain of the second field-effect transistor; an operational amplifier having its positive input and negative input connected to the collectors of the first bipolar transistor and the second bipolar transistor, respectively, and its output connected to the bases of the first bipolar transistor and the second bipolar transistor; and a third and fourth field-effect transistor for making the currents flowing through the first bipolar transistor and the second bipolar transistor the same. A resistor of the second field-effect transistor between its drain and source during conduction is larger than a resistance of the first field-effect transistor between its drain and source, and wherein a drain voltage of the first field-effect transistor is kept to be equal to a drain voltage of the second field-effect transistor via a feedback loop formed by the first bipolar transistor, the second bipolar transistor and the operational amplifier.

An integrated circuit according to an embodiment of the present disclosure comprises: a working circuit having a first power semiconductor device; and the aforementioned current sensing circuit.

Embodiments of the present disclosure are set out by the dependent claims.

It can be seen from the above that an embodiment of the present disclosure reduces the input offset of an operational amplifier simply by adding two bipolar transistors. Therefore, compared with the prior art, the solution of the present disclosure can reduce the input offset of an operational amplifier without increasing the complexity or the cost of the circuit.

### Brief Description of the Drawings

The features, characteristics, advantages, and benefits of the present disclosure will become apparent from the following detailed description taken in conjunction with the accompanying drawings.
Figure 1 shows a schematic structural diagram of an integrated circuit according to an embodiment of the present disclosure;
Figure 2 shows a schematic structural diagram of an integrated circuit according to another embodiment of the present disclosure;
Figure 3 shows a schematic structural diagram of an integrated circuit according to a further embodiment of the present disclosure.

### Specific Embodiments

Various embodiments of the present disclosure will be described in detail below with reference to the accompanying drawings.

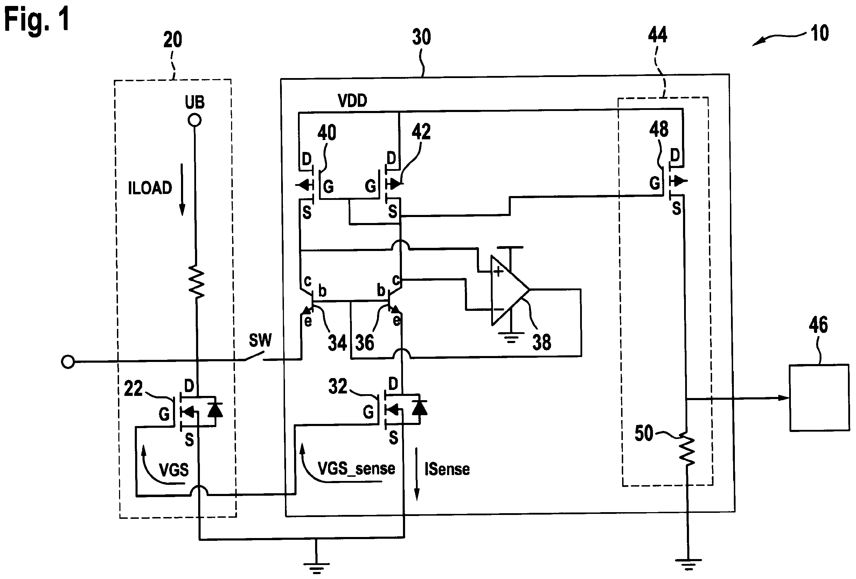

Figure 1 shows a schematic diagram of an integrated circuit according to an embodiment of the present disclosure. The integrated circuit 10 shown in Figure 1 may be, for example, but not limited to, a PFI valve needle.

As shown in Figure 1, the integrated circuit 10 may comprise a working circuit 20 and a current sensing circuit 30.

The working circuit 20 may comprise an N-channel type field-effect transistor 22, wherein the operating current flowing through the working field-effect transistor 22 is denoted as ILOAD. The source S of the field-effect transistor 22 is grounded, and the drain D of the working field-effect transistor 22 is connected to the power source UB via the load.

The current sensing circuit 30 may comprise an N-channel type field-effect transistor 32, two PNP type bipolar transistors 34 and 36, an operational amplifier 38, P-channel type field-effect transistors 40 and 42, and a conversion circuit 44.

The field-effect transistor 32 functions as a sensing field-effect transistor, which can generate a sensing current ISense proportional to the operating current ILOAD of the field-effect transistor 22, wherein the ratio of the sensing current ISense to the operating current ILOAD is referred to as the current mirror ratio. The gate G of the field-effect transistor 32 is connected to the gate G of the field-effect transistor 22, and the source S of the field-effect transistor 32, like the source S of the field-effect transistor 22, is grounded.

The bipolar transistors 34 and 36 are two identical transistors. The base b of the bipolar transistor 34 and the base b of the bipolar transistor 36 are connected together. The emitter e of the bipolar transistor 34 is connected to the drain D of the field-effect transistor 22 via a switch sw, and the emitter e of the bipolar transistor 36 is connected to the drain D of the field-effect transistor 32.

The positive input + and the negative input - of the operational amplifier 38 are connected to the collector c of the bipolar transistor 34 and the collector c of the bipolar transistor 36, respectively. The output of the operational amplifier 38 is connected to the bases b of the bipolar transistors 34 and 36.

The field-effect transistors 40 and 42 are two identical field-effect transistors for making the currents flowing through the bipolar transistors 34 and 36 the same. The gate G of the field-effect transistor 40 and the gate G of the field-effect transistor 42 are connected together. The source S and the drain D of the field-effect transistor 40 are connected to the collector c of the bipolar transistor 34 and the power source VDD, respectively. The source S of the field-effect transistor 42 is connected to the collector c of the bipolar transistor 36 and the gates G of the field-effect transistors 40, 42, and the drain D of the field-effect transistor 42 is connected to the power source VDD.

The conversion circuit 44 is used to convert the sensing current ISense into a voltage and output it to the microcontroller 46. The conversion circuit 44 may comprise a P-channel type field-effect transistor 48 and a resistor 50. The gate G of the field-effect transistor 48 is connected between the source S of the field-effect transistor 42 and the collector c of the bipolar transistor 36, and the drain D of the field-effect transistor 48 is connected to the power source VDD. The resistor 50 is connected between the source S of the field-effect transistor 48 and the ground. The microcontroller 46 is connected between the resistor 50 and the source S of the field-effect transistor 48. Here, the sensing current ISense is converted into a voltage via the field-effect transistor 48 and the resistor 50 and is output to the microcontroller 46. Then, the microcontroller 46 uses the received voltage to calculate the sensing current ISense and, based on the sensing current ISense and the current mirror ratio of the sensing current ISense to the operating current ILOAD, calculates the operating current ILOAD so that the operating current of the operating circuit 20 is known.

The principle of reducing the influence of the input offset of the operational amplifier 38 on the current sensing according to the present embodiment is described as below.

As shown in Figure 1, the bipolar transistors 34 and 36 function as an input pair for the field-effect transistors 22 and 32. Since bipolar transistors have excellent matching performance (i.e. the mismatch is small), the operational amplifier 38 can keep the drain voltages of the field-effect transistors 22 and 32 the same via a feedback loop formed by the operational amplifier 38 and the bipolar transistors 34 and 36. For example, if the voltage at the positive input + of the operational amplifier 38 is greater than the voltage at the negative input - of the operational amplifier 38, the output voltage of the operational amplifier 38 increases. Since the resistance Rdson of the field-effect transistor 32 between the drain D and the source S during conduction is much larger than the resistance Rdson of the field-effect transistor 22, the increase in the current flowing through the field-effect transistor 32 is smaller than the increase in the current flowing through the field-effect transistor 22. As a result, the voltage at the positive input + of the operational amplifier 38 drops to the same voltage as the negative input - of the operational amplifier 38. In this case, the same current flows through the bipolar transistors 34 and 36, so that the drain voltage of the field-effect transistor 32 is equal to the drain voltage of the field-effect transistor 22. Thus, the current mirror ratio of the sensing current ISense to the operating current I LOAD remains basically unaffected by the input offset of the operational amplifier 38. Therefore, the influence of the input offset of the operational amplifier 38 on the current sensing is reduced.

As can be seen from the above description, this embodiment can reduce the influence of the input offset of the operational amplifier on the current sensing by adding only two bipolar transistors, while adding two bipolar transistors hardly increases the cost or the complexity of the circuit. Therefore, compared with the prior art, the solution of this embodiment can reduce the input offset of an operational amplifier without increasing the complexity or the cost of the circuit.

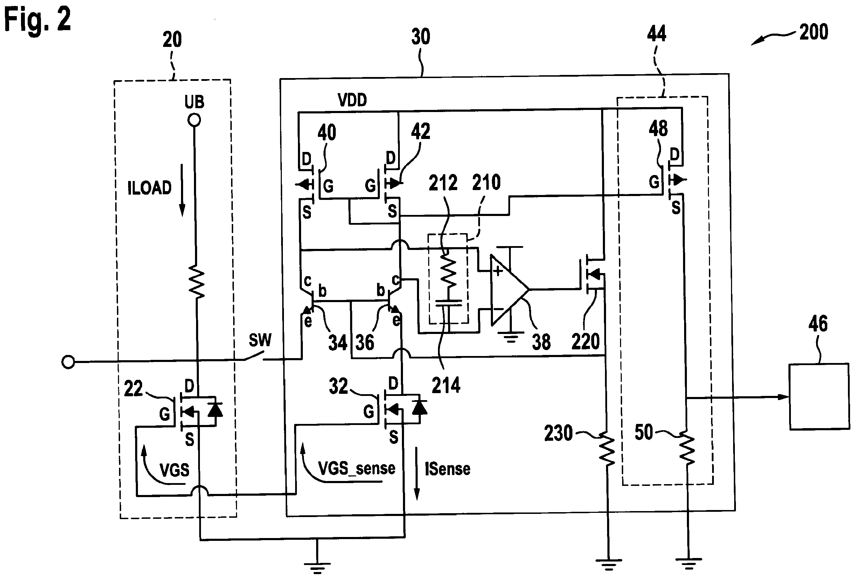

Figure 2 shows a schematic diagram of an integrated circuit according to another embodiment of the present disclosure. The integrated circuit 200 shown in Figure 2 is different from the integrated circuit 10 shown in Figure 1 in that the current sensing circuit 30 in the integrated circuit 200 further comprises a filter circuit 210, a field-effect transistor 220, and a resistor 230.

The filter circuit 210 is connected between the positive input + and the negative input - of the operational amplifier 38 for filtering out noise components present in the feedback loop formed by the operational amplifier 38 and the bipolar transistors 34 and 36 so that the feedback loop remains stable. The filter circuit 210 may comprise a resistor 212 and a capacitor 214 connected in series.

The gate G of the field-effect transistor 220 is connected to the output of the operational amplifier 38, and the drain D of the field-effect transistor 220 is connected to the power source VDD. The resistor 230 is connected between the source S of the field-effect transistor 220 and the ground. The gates G of the field-effect transistors 40 and 42 are connected between the resistor 230 and the source S of the field-effect transistor 220. The addition of the field-effect transistor 220 and the resistor 230 can enhance the driving ability of the operational amplifier 38.

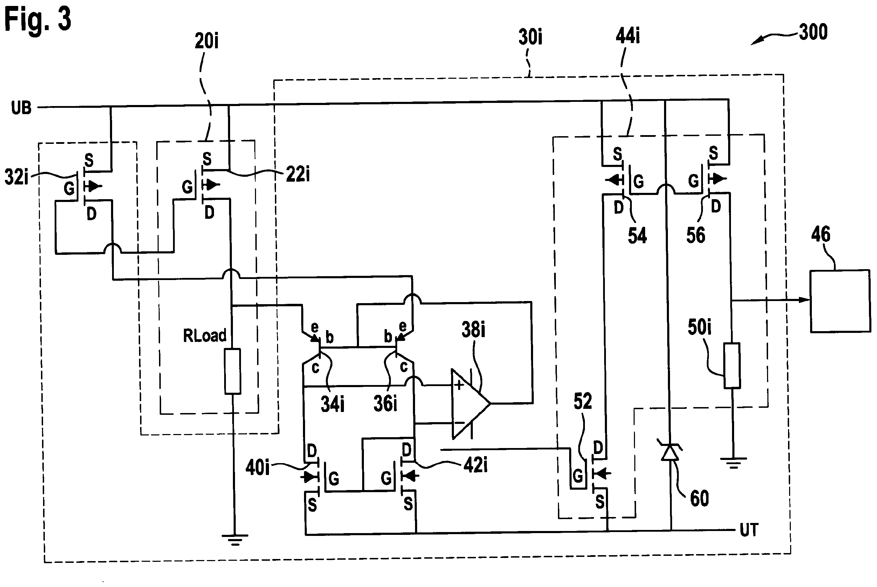

Figure 3 shows a schematic diagram of an integrated circuit according to a further embodiment of the present disclosure.

As shown in Figure 3, the integrated circuit 300 may comprise a working circuit 20i and a current sensing circuit 30i.

The working circuit 20i may comprise a P-channel type field-effect transistor 22i, wherein the operating current flowing through the field-effect transistor 22i is denoted as ILOAD. The source S of the field-effect transistor 22i is connected to the power source UB, and the drain D of the field-effect transistor 22i is connected to the ground via the load.

The current sensing circuit 30i may comprise a P-channel type field-effect transistor 32i, two NPN type bipolar transistors 34i and 36i, an operational amplifier 38i, N-channel type field-effect transistors 40i and 42i, a conversion circuit 44i, and a voltage regulator 60.

The field-effect transistor 32i functions as a sensing field-effect transistor, which can generate a sensing current ISense that is proportional to the operating current ILOAD of the field-effect transistor 22i, wherein the ratio of the sensing current ISense to the operating current ILOAD is referred to as the current mirror ratio.

The gate G of the field-effect transistor 32i is connected to the gate G of the field-effect transistor 22i, and the source S of the field-effect transistor 32i, like the source S of the field-effect transistor 22i, is connected to the power source UB.

The bipolar transistors 34i and 36i are two identical transistors. The base b of the bipolar transistor 34i and the base b of the bipolar transistor 36i are connected together. The emitter e of the bipolar transistor 34i is connected to the drain D of the field-effect transistor 22i, and the emitter e of the bipolar transistor 36i is connected to the drain D of the field-effect transistor 32i.

The positive input + and the negative input - of the operational amplifier 38i are respectively connected to the collector c of the bipolar transistor 34i and the collector c of the bipolar transistor 36i. The output of the operational amplifier 38i is connected to the bases b of the bipolar transistors 34i and 36i.

The field-effect transistors 40i and 42i are two identical field-effect transistors for making the currents flowing through the bipolar transistors 34i and 36i the same. The gate G of the field-effect transistor 40i and the gate G of the field-effect transistor 42i are connected together. The drain D and the source S of the field-effect transistor 40i are respectively connected to the collector c of the bipolar transistor 34i and the power source VT, wherein the voltage of the power source VT is smaller than the voltage of the power source VB by a predetermined voltage value (for example, 5 V). The drain D of the field-effect transistor 42i is connected to the collector c of the bipolar transistor 36i and the gate G of the field-effect transistors 40i, 42i, and the source S of the field-effect transistor 42i is connected to the power source VT.

The voltage regulator 60 is connected between the power source VB and the power source VT to ensure that the voltage of the power source VT is smaller than the voltage of the power source VB by a predetermined voltage value.

The conversion circuit 44i is used to convert the sensing current ISense into a voltage and output it to the microcontroller 46. In one aspect, the conversion circuit 44i may comprise an N-channel type field-effect transistor 52, P-channel type field-effect transistors 54 and 56, and a resistor 50i. The gate G of the field-effect transistor 52 is connected to the gate D of the field-effect transistor 42i, and the source S of the field-effect transistor 52 is connected to the power source VT. The gates G of the field-effect transistors 54 and 56 are connected together and connected to the drain D of the field-effect transistor 54. The source S and the drain D of the field-effect transistor 54 are connected to the power source UB and the drain D of the field-effect transistor 52, respectively. The source S of the field-effect transistor 56 is connected to the power source UB. The resistor 50i is connected between the drain D of the field-effect transistor 56 and the ground. The microcontroller 46 is connected between the resistor 50i and the drain D of the field-effect transistor 56. Here, the sensing current ISense is converted into a voltage via the field-effect transistors 52, 54, 56 and the resistor 50i and is output to the microcontroller 46. Then, the microcontroller 46 uses the received voltage to calculate the sensing current ISense and, based on the sensing current ISense and the current mirror ratio of the sensing current ISense to the operating current ILOAD, calculates the operating current ILOAD so that the operating current of the operating circuit 20i is known.

### Other variants

Those of ordinary skill in the art will understand that the field-effect transistors used in the integrated circuits 10, 200, and 300 may be metal-oxide-semiconductor field-effect transistors (MOSFETs) or other types of field-effect transistors.

Those of ordinary skill in the art should understand that although in the above embodiment the conversion circuit 44 is implemented using the MOSFET 48 and the resistor 50, the present disclosure is not limited thereto. In some other embodiments of the present disclosure, the conversion circuit 44 can also be implemented in other manners.

Those of ordinary skill in the art should understand that although in the above embodiment the conversion circuit 44i is implemented using the field-effect transistors 52, 54, 56 and the resistor 50i, the present disclosure is not limited thereto. In some other embodiments of the present disclosure, the conversion circuit 44i may also be implemented in other manners.

Those of ordinary skill in the art should understand that the filter circuit 210 may also be applied between the positive input + and the negative input - of the operational amplifier 38i shown in Figure 3.

Those of ordinary skill in the art should understand that although in the above embodiment the filter circuit 210 is implemented using the resistor 212 and the capacitor 214, the present disclosure is not limited thereto. In some other embodiments of the present disclosure, the filter circuit 210 can also be implemented in other manners.

Those of ordinary skill in the art should understand that, in some other embodiments of the present disclosure, the current sensing circuit 30i shown in Figure 3 may not comprise the voltage regulator 60.

Those of ordinary skill in the art should understand that although in the above embodiment the conversion circuits 44 and 44i are used to convert the sensing current ISense into a voltage and output it to the microcontroller 46, the present disclosure is not limited thereto. In some other embodiments of the present disclosure, the conversion circuits 44 and 44i may also be used to convert the sensing current ISense into a non-current signal, for example an optical signal or an electromagnetic signal, other than a voltage and output it to the microcontroller 46.

Those of ordinary skill in the art should understand that although in the above embodiment the current sensing circuit 30 or 30i comprises a conversion circuit 44 or 44i for converting the sensing current ISense into a non-current signal (e.g. a voltage, an optical signal, or an electromagnetic signal) and outputting it to the microcontroller 46, the present disclosure is not limited thereto. In some other embodiments of the present disclosure, the current sensing circuit 30 or 30i can directly output the sensing current ISense to the microcontroller 46 without converting it into a non-current signal. In this case, the current sensing circuit 30 or 30i may not need to comprise a conversion circuit.

Those of ordinary skill in the art should understand that although in the above embodiment the sensing current ISense from the conversion circuit 44 or 44i or a non-current signal (e.g. a voltage, an optical signal, or electromagnetic signal) converted from the sensing current ISense is processed by the microcontroller 46, the present disclosure is not limited thereto. In some other embodiments of the present disclosure, the sensing current ISense from the conversion circuit 44 or 44i or a non-current signal converted from the sensing current ISense may be processed using other suitable devices other than a microcontroller, such as a computer or an industrial controller.

An embodiment of the present disclosure provides a current sensing circuit, characterized in that the circuit comprises: a second field-effect transistor for generating a sensing current proportional to the current flowing through a working circuit having a first field-effect transistor; a first bipolar transistor and a second bipolar transistor having bases connected together, wherein the emitter of the first bipolar transistor and the emitter of the second bipolar transistor are respectively connected to the drain of the first field-effect transistor and the drain of the second field-effect transistor; an operational amplifier having its positive input and negative input connected to the collectors of the first bipolar transistor and the second bipolar transistor, respectively, and its output connected to the bases of the first bipolar transistor and the second bipolar transistor; and a third and fourth field-effect transistor for making the currents flowing through the first bipolar transistor and the second bipolar transistor the same.

In the first aspect, the second field-effect transistor is of an N-channel type, the third field-effect transistor and the fourth field-effect transistor are of a P-channel type, and the first and second bipolar transistors are of the PNP type, the source of the second field-effect transistor is grounded, the gates of the third field-effect transistor and the fourth field-effect transistor are connected together and connected to the collector of the second bipolar transistor, the drain and the source of the third field-effect transistor are connected to a first power source and the collector of the first bipolar transistor, respectively, and the drain and the source of the fourth field-effect transistor are respectively connected to the first power source and the collector of the second bipolar transistor.

In the second aspect, the second field-effect transistor is of a P-channel type, the third field-effect transistor and the fourth field-effect transistor are of an N-channel type, and the first and second bipolar transistors are of an NPN type, the source of the second field-effect transistor is connected to a second power source, the gates of the third field-effect transistor and the fourth field-effect transistor are connected together and connected to the collector of the second bipolar transistor, the source and the drain of the third field-effect transistor are respectively connected to a third power source and the collector of the first bipolar transistor, wherein the voltage of the third power source is lower than the voltage of the second power source, and the source and the drain of the fourth field-effect transistor are respectively connected to the third power source and the collector of the second bipolar transistor.

In the third aspect, the current sensing circuit further comprises a conversion circuit for converting the sensing current into a non-current signal and outputting it to another device.

In the fourth aspect, the second field-effect transistor is of an N-channel type, the third field-effect transistor and the fourth field-effect transistor are of a P-channel type, and the first and second bipolar transistors are of a PNP type, the source of the second field-effect transistor is grounded, the gates of the third field-effect transistor and the fourth field-effect transistor are connected together and connected to the collector of the second bipolar transistor, the drain and the source of the third field-effect transistor are connected to a first power source and the collector of the first bipolar transistor, respectively, and the drain and the source of the fourth field-effect transistor are respectively connected to the first power source and the collector of the second bipolar transistor.

In the fifth aspect, the conversion circuit comprises a fifth field-effect transistor and a first resistor, wherein the gate and the drain of the fifth field-effect transistor are connected to the collector of the second bipolar transistor and the first power source, respectively, and the first resistor is connected between the source of the fifth field-effect transistor and the ground, and said other device is connected between the source of the fifth field-effect transistor and the first resistor.

In the sixth aspect, the second field-effect transistor is of a P-channel type, the third field-effect transistor and the fourth field-effect transistor are of an N-channel type, and the first and second bipolar transistors are of an NPN type, the source of the second field-effect transistor is connected to a second power source, the gates of the third field-effect transistor and the fourth field-effect transistor are connected together and connected to the collector of the second bipolar transistor, the source and the drain of the third field-effect transistor are respectively connected to a third power source and the collector of the first bipolar transistor, wherein the voltage of the third power source is lower than the voltage of the second power source, and the source and the drain of the fourth field-effect transistor are respectively connected to the third power source and the collector of the second bipolar transistor.

In the seventh aspect, the conversion circuit comprises a sixth field-effect transistor, a seventh field-effect transistor, an eighth field-effect transistor, and a second resistor, the gate, the source and the drain of the sixth field-effect transistor are respectively connected to the drain of the fourth field-effect transistor, the third power source, and the drain of the seventh field-effect transistor, the sources of the seventh field-effect transistor and the eighth field-effect transistor are connected to the second power source, the gates of the seventh field-effect transistor and the eighth field-effect transistor are connected together and connected to the drain of the seventh field-effect transistor, the second resistor is connected between the gate of the eighth field-effect transistor and the third power source, and said other device is connected between the gate of the eighth field-effect transistor and the second resistor.

In the eighth aspect, the current sensing circuit further comprises: a filter circuit connected between the positive input and the negative input of the operational amplifier.

In the ninth aspect, the current sensing circuit further comprises: a ninth field-effect transistor having its gate and drain respectively connected to the output of the operational amplifier and the first power source; and a third resistor connected between the source of the ninth field-effect transistor and the ground, wherein the bases of the first and second bipolar transistors are connected between the source of the ninth field-effect transistor and the third resistor.

An embodiment of the present disclosure provides an integrated circuit comprising: a working circuit having a first field-effect transistor; and the aforementioned current sensing circuit.

## Claims

1. Current sensing circuit (30, 30i) comprising
a second field-effect transistor (32, 32i) for generating a sensing current proportional to a current flowing through a working circuit (20, 20i) having a first field-effect transistor (22, 22i);
a first bipolar transistor (34, 34i) and a second bipolar transistor (36, 36i) having bases connected together, wherein emitters of the first bipolar transistor (34, 34i) and the second bipolar transistor (36, 36i) are respectively connected to drains of the first field-effect transistor (22, 22i) and the second field-effect transistor (32, 32i);
an operational amplifier (38, 38i) having its positive input and negative input connected to collectors of the first bipolar transistor (34, 34i) and the second bipolar transistor (36, 36i), respectively, and its output connected to the bases of the first bipolar transistor (34, 34i) and the second bipolar transistor (36, 36i); and
a third and fourth field-effect transistors (40, 40i, 42, 42i) for making currents flowing through the first bipolar transistor (34, 34i) and the second bipolar transistor (36, 36i) the same,
wherein a resistance of the second field-effect transistor (32, 32i) between its drain (D) and source (S) during conduction is larger than a resistance of the first field-effect transistor (22, 22i) between its drain (D) and source (S) during conduction, and
wherein a drain voltage of the first field-effect transistor (22, 22i) is kept to be equal to a drain voltage of the second field-effect transistor (32, 32i) via a feedback loop formed by the first bipolar transistor (34, 34i), the second bipolar transistor (36, 36i) and the operational amplifier (38, 38i).

2. Current sensing circuit (30) according to Claim 1, **characterized in that**
the second field-effect transistor (32i) is of an N-channel type, the third field-effect transistor (40) and the fourth field-effect transistor (42) are of a P-channel type, and the first and second bipolar transistors (34, 36) are of a PNP type,
a source of the second field-effect transistor (32) is grounded,
gates of the third field-effect transistor (40) and the fourth field-effect transistor (42) are connected together and connected to the collector of the second bipolar transistor (36),
a drain and a source of the third field-effect transistor (40) are respectively connected to a first power source (VDD) and the collector of the first bipolar transistor (34), and
a drain and a source of the fourth field-effect transistor (42) are respectively connected to the first power source (VDD) and the collector of the second bipolar transistor (36).

3. Current sensing circuit (30i) according to Claim 1, **characterized in that**
the second field-effect transistor (32i) is of a P-channel type, the third field-effect transistor (40i) and the fourth field-effect transistor (42i) are of an N-channel type, and the first and second bipolar transistors (34i, 36i) are of an NPN type,
a source of the second field-effect transistor (32i) is connected to a second power source (UB),
gates of the third field-effect transistor (40i) and the fourth field-effect transistor (42i) are connected together and connected to the collector of the second bipolar transistor (36i),
a source and a drain of the third field-effect transistor (40i) are respectively connected to a third power source (VT) and the collector of the first bipolar transistor (34i), wherein a voltage of the third power source (VT) is lower than a voltage of the second power source (UB), and
a source and a drain of the fourth field-effect transistor (42i) are respectively connected to the third power source (VT) and the collector of the second bipolar transistor (36i).

4. Current sensing circuit (30, 30i) according to Claim 1, **characterized in that** it further comprises:
a conversion circuit (44, 44i) for converting the sensing current into a non-current signal and outputting it to another device (46).

5. Current sensing circuit (30) according to Claim 4, **characterized in that**
the second field-effect transistor (32i) is of an N-channel type, the third field-effect transistor (40) and the fourth field-effect transistor (42) are of a P-channel type, and the first and second bipolar transistors (34, 36) are of a PNP type,
a source of the second field-effect transistor (32) is grounded,
gates of the third field-effect transistor (40) and the fourth field-effect transistor (42) are connected together and connected to the collector of the second bipolar transistor (36),
a drain and a source of the third field-effect transistor (40) are respectively connected to a first power source (VDD) and the collector of the first bipolar transistor (34), and
a drain and a source of the fourth field-effect transistor (42) are respectively connected to the first power source (VDD) and the collector of the second bipolar transistor (36).

6. Current sensing circuit (30) according to Claim 5, **characterized in that**
the conversion circuit (44) comprises a fifth field-effect transistor (48) and a first resistor (50), wherein the gate and the drain of the fifth field-effect transistor (48) are respectively connected to the collector of the second bipolar transistor (36) and the first power source (VDD), and the first resistor (50) is connected between the source of the fifth field-effect transistor (48) and the ground, and
said other device (46) is connected between the source of the fifth field-effect transistor (48) and the first resistor (50).

7. Current sensing circuit (30i) according to Claim 4, **characterized in that**
the second field-effect transistor (32i) is of a P-channel type, the third field-effect transistor (40i) and the fourth field-effect transistor (42i) are of an N-channel type, and the first and second bipolar transistors (34i, 36i) are of an NPN type,
a source of the second field-effect transistor (32i) is connected to a second power source (UB),
gates of the third field-effect transistor (40i) and the fourth field-effect transistor (42i) are connected together and connected to the collector of the second bipolar transistor (36i),
a source and a drain of the third field-effect transistor (40i) are respectively connected to a third power source (VT) and the collector of the first bipolar transistor (34i), wherein a voltage of the third power source (VT) is lower than a voltage of the second power source (UB), and
a source and a drain of the fourth field-effect transistor (42i) are respectively connected to the third power source (VT) and the collector of the second bipolar transistor (36i).

8. Current sensing circuit (30i) according to Claim 7, **characterized in that**,
the conversion circuit (44i) comprises a sixth field-effect transistor (52), a seventh field-effect transistor (54), an eighth field-effect transistor (56), and a second resistor (50i),
a gate, a source, and a drain of the sixth field-effect transistor (52) are respectively connected to the drain of the fourth field-effect transistor (42i), the third power source (VT), and a drain of the seventh field-effect transistor (54),
sources of the seventh field-effect transistor (54) and the eighth field-effect transistor (56) are connected to the second power source (UB),
gates of the seventh field-effect transistor (54) and the eighth field-effect transistor (56) are connected together and connected to the drain of the seventh field-effect transistor (54),
the second resistor (50i) is connected between the gate of the eighth field-effect transistor (56) and the third power source (VT), and
said other device (46) is connected between the gate of the eighth field-effect transistor (56) and the second resistor (50i).

9. Current sensing circuit (30, 30i) according to Claim 1, **characterized in that** it further comprises:
a filter circuit (210) connected between a positive input and a negative input of the operational amplifier (38, 38i).

10. Current sensing circuit (30) according to Claim 2 or Claim 5, **characterized in that** it further comprises:
a ninth field-effect transistor (230) having its gate and drain respectively connected to the output of the operational amplifier (38, 38i) and the first power source (VDD); and
a third resistor (230) connected between a source of the ninth field-effect transistor (230) and the ground,
wherein the bases of the first and second bipolar transistors (34, 34i, 36, 36i) are connected between the source of the ninth field-effect transistor (230) and the third resistor (230).

11. Integrated circuit (10, 200, 300), **characterized in that** it comprises:
a working circuit (20, 20i) having a first field-effect transistor (22, 22i); and
a current sensing circuit (30, 30i) according to any one of Claims 1 to 10.

## Patentansprüche

1. Stromerfassungsschaltung (30, 30i), die Folgendes umfasst:
einen zweiten Feldeffekttransistor (32, 32i) zum Erzeugen eines Erfassungsstroms proportional zu einem Strom, der durch eine Arbeitsschaltung (20, 20i) mit einem ersten Feldeffekttransistor (22, 22i) fließt;
einen ersten Bipolartransistor (34, 34i) und einen zweiten Bipolartransistor (36, 36i) mit miteinander verbundenen Basen, wobei Emitter des ersten Bipolartransistors (34, 34i) und des zweiten Bipolartransistors (36, 36i) mit Drains des ersten Feldeffekttransistors (22, 22i) bzw. des zweiten Feldeffekttransistors verbunden sind (32, 32i);
einen Operationsverstärker (38, 38i) dessen positiver Eingang und negativer Eingang mit Kollektoren des ersten Bipolartransistors (34, 34i) bzw. des zweiten Bipolartransistors (36, 36i) verbunden sind und dessen Ausgang mit den Basen des ersten Bipolartransistors (34, 34i) und des zweiten Bipolartransistors (36, 36i) verbunden ist; und
einen dritten und vierten Feldeffekttransistor (40, 40i, 42, 42i) zum Bewirken, dass durch den ersten Bipolartransistor (34, 34i) und den zweiten Bipolartransistor (36, 36i) fließende Ströme gleich sind,
wobei ein Widerstand des zweiten Feldeffekttransistors (32, 32i) zwischen seinem Drain (D) und seiner Source (S) während der Leitung größer als ein Widerstand des ersten Feldeffekttransistors (22, 22i) zwischen seinem Drain (D) und seiner Source (S) während der Leitung ist und
wobei eine Drain-Spannung des ersten Feldeffekttransistors (22, 22i) über eine Rückkopplungsschleife, die durch den ersten Bipolartransistor (34, 32), den zweiten Bipolartransistor (32i, 36i) und den Operationsverstärker (38, 38i) gebildet wird, gleich einer Drain-Spannung des zweiten Feldeffekttransistors (34i, 36) gehalten wird.

2. Stromerfassungsschaltung (30) nach Anspruch 1, **dadurch gekennzeichnet, dass**
der zweite Feldeffekttransistor (32i) vom N-Kanal-Typ ist, der dritte Feldeffekttransistor (40) und der vierte Feldeffekttransistor (42) vpm P-Kanal-Typ sind und der erste und der zweite Bipolartransistor (34, 36) vom PNP-Typ sind,
eine Source des zweiten Feldeffekttransistors (32) auf Masse gelegt ist,
die Gates des dritten Feldeffekttransistors (40) und des vierten Feldeffekttransistors (42) miteinander verbunden sind und mit dem Kollektor des zweiten Bipolartransistors (36) verbunden sind,
ein Drain und eine Source des dritten Feldeffekttransistors (40) mit einer ersten Stromquelle (VDD) bzw. dem Kollektor des ersten Bipolartransistors (34) verbunden sind und
ein Drain und eine Source des vierten Feldeffekttransistors (42) mit der ersten Stromquelle (VDD) bzw. dem Kollektor des zweiten Bipolartransistors (36) verbunden sind.

3. Stromerfassungsschaltung (30i) nach Anspruch 1, **dadurch gekennzeichnet, dass**
der zweite Feldeffekttransistor (32i) vom P-Kanal-Typ ist, der dritte Feldeffekttransistor (40i) und der vierte Feldeffekttransistor (42i) vom N-Kanal-Typ sind und der erste und der zweite Bipolartransistor (34i, 36i) vom PNP-Typ sind,
eine Source des zweiten Feldeffekttransistors (32i) mit einer zweiten Stromquelle (UB) verbunden ist,
die Gates des dritten Feldeffekttransistors (40i) und des vierten Feldeffekttransistors (42i) miteinander verbunden sind und mit dem Kollektor des zweiten Bipolartransistors (36i) verbunden sind,
eine Source und ein Drain des dritten Feldeffekttransistors (40i) mit einer dritten Stromquelle (VT) bzw. dem Kollektor des ersten Bipolartransistors (34i) verbunden sind, wobei eine Spannung der dritten Stromquelle (VT) niedriger als eine Spannung der zweiten Stromquelle (UB) ist, und eine Source und ein Drain des vierten Feldeffekttransistors (42i) mit der dritten Stromquelle (VT) bzw. dem Kollektor des zweiten Bipolartransistors (36i) verbunden sind.

4. Stromerfassungsschaltung (30, 30i) nach Anspruch 1, **dadurch gekennzeichnet, dass** sie ferner Folgendes umfasst:
eine Umwandlungsschaltung (44, 44i), um den Erfassungsstrom in ein Nicht-Strom-Signal umzuwandeln und ihn an eine andere Vorrichtung (46) auszugeben.

5. Stromerfassungsschaltung (30) nach Anspruch 4, **dadurch gekennzeichnet, dass**
der zweite Feldeffekttransistor (32i) vom N-Kanal-Typ ist, der dritte Feldeffekttransistor (40) und der vierte Feldeffekttransistor (42) vpm P-Kanal-Typ sind und der erste und der zweite Bipolartransistor (34, 36) vom PNP-Typ sind,
eine Source des zweiten Feldeffekttransistors (32) auf Masse gelegt ist,
die Gates des dritten Feldeffekttransistors (40) und des vierten Feldeffekttransistors (42) miteinander verbunden sind und mit dem Kollektor des zweiten Bipolartransistors (36) verbunden sind,
ein Drain und eine Source des dritten Feldeffekttransistors (40) mit einer ersten Stromquelle (VDD) bzw. dem Kollektor des ersten Bipolartransistors (34) verbunden sind und
ein Drain und eine Source des vierten Feldeffekttransistors (42) mit der ersten Stromquelle (VDD) bzw. dem Kollektor des zweiten Bipolartransistors (36) verbunden sind.

6. Stromerfassungsschaltung (30) nach Anspruch 5, **dadurch gekennzeichnet, dass**
die Umwandlungsschaltung (44) einen fünften Feldeffekttransistor (48) und einen ersten Widerstand (50) umfasst, wobei das Gate und der Drain des fünften Feldeffekttransistors (48) jeweils mit dem Kollektor des zweiten Bipolartransistors (36) und der ersten Stromquelle (VDD) verbunden sind und der erste Widerstand (50) zwischen die Source des fünften Feldeffekttransistors (48) und Masse geschaltet ist, und
die andere Vorrichtung (46) zwischen die Source des fünften Feldeffekttransistors (48) und den ersten Widerstand (50) geschaltet ist.

7. Stromerfassungsschaltung (30i) nach Anspruch 4, **dadurch gekennzeichnet, dass**
der zweite Feldeffekttransistor (32i) vom P-Kanal-Typ ist, der dritte Feldeffekttransistor (40i) und der vierte Feldeffekttransistor (42i) vom N-Kanal-Typ sind und der erste und der zweite Bipolartransistor (34i, 36i) vom PNP-Typ sind,
eine Source des zweiten Feldeffekttransistors (32i) mit einer zweiten Stromquelle (UB) verbunden ist,
die Gates des dritten Feldeffekttransistors (40i) und des vierten Feldeffekttransistors (42i) miteinander verbunden sind und mit dem Kollektor des zweiten Bipolartransistors (36i) verbunden sind,
eine Source und ein Drain des dritten Feldeffekttransistors (40i) mit einer dritten Stromquelle (VT) bzw. dem Kollektor des ersten Bipolartransistors (34i) verbunden sind, wobei eine Spannung der dritten Stromquelle (VT) niedriger als eine Spannung der zweiten Stromquelle (UB) ist, und
eine Source und ein Drain des vierten Feldeffekttransistors (42i) mit der dritten Stromquelle (VT) bzw. dem Kollektor des zweiten Bipolartransistors (36i) verbunden sind.

8. Stromerfassungsschaltung (30i) nach Anspruch 7, **dadurch gekennzeichnet, dass**
die Umwandlungsschaltung (44i) einen sechsten Feldeffekttransistor (52), einen siebten Feldeffekttransistor (54), einen achten Feldeffekttransistor (56) und einen zweiten Widerstand (50i) umfasst,
ein Gate, eine Source und ein Drain des sechsten Feldeffekttransistors (52) mit dem Drain des vierten Feldeffekttransistors (42i), der dritten Stromquelle (VT) bzw. einem Drain des siebten Feldeffekttransistors (54) verbunden sind,
Sources des siebten Feldeffekttransistors (54) und des achten Feldeffekttransistors (56) mit der zweiten Stromquelle (UB) verbunden sind,
Gates des siebten Feldeffekttransistors (54) und des achten Feldeffekttransistors (56) miteinander verbunden sind und mit dem Drain des siebten Feldeffekttransistors (54) verbunden sind,
der zweite Widerstand (50i) zwischen das Gate des achten Feldeffekttransistors (56) und die dritte Stromquelle (VT) geschaltet ist und
die andere Vorrichtung (46) zwischen das Gate des achten Feldeffekttransistors (56) und den zweiten Widerstand (50i) geschaltet ist.

9. Stromerfassungsschaltung (30, 30i) nach Anspruch 1, **dadurch gekennzeichnet, dass** sie ferner Folgendes umfasst:
eine Filterschaltung (210), die zwischen einen positiven Eingang und einen negativen Eingang des Operationsverstärkers (38, 38i) geschaltet ist.

10. Stromerfassungsschaltung (30) nach Anspruch 2 oder Anspruch 5, **dadurch gekennzeichnet, dass** sie ferner Folgendes umfasst:
einen neunten Feldeffekttransistor (230), dessen Gate und Drain mit dem Ausgang des Operationsverstärkers (38, 38i) bzw. der ersten Stromquelle (VDD) verbunden sind; und
einen dritten Widerstand (230), der zwischen eine Source des neunten Feldeffekttransistors (230) und Masse geschaltet ist,
wobei die Basen des ersten und des zweiten Bipolartransistors (34, 34i, 36, 36i) zwischen die Source des neunten Feldeffekttransistors (230) und den dritten Widerstand (230) geschaltet sind.

11. Integrierte Schaltung (10, 200, 300), **dadurch gekennzeichnet, dass** sie Folgendes umfasst:
eine Arbeitsschaltung (20, 20i) mit einem ersten Feldeffekttransistor (22, 22i); und
eine Stromerfassungsschaltung (30, 30i) nach einem der Ansprüche 1 bis 10.

## Revendications

1. Circuit de détection de courant (30, 30i) comprenant :
un deuxième transistor à effet de champ (32, 32i) pour générer un courant de détection proportionnel à un courant circulant à travers un circuit de travail (20, 20i) ayant un premier transistor à effet de champ (22, 22i) ;
un premier transistor bipolaire (34, 34i) et un deuxième transistor bipolaire (36, 36i) ayant des bases connectées ensemble, des émetteurs du premier transistor bipolaire (34, 34i) et du deuxième transistor bipolaire (36, 36i) étant respectivement connectés à des drains du premier transistor à effet de champ (22, 22i) et du deuxième transistor à effet de champ (32, 32i) ;
un amplificateur opérationnel (38, 38i) ayant son entrée positive et son entrée négative connectées à des collecteurs du premier transistor bipolaire (34, 34i) et du deuxième transistor bipolaire (36, 36i), respectivement, et sa sortie connectée aux bases du premier transistor bipolaire (34, 34i) et du deuxième transistor bipolaire (36, 36i) ; et
un troisième et un quatrième transistor à effet de champ (40, 40i, 42, 42i) pour rendre des courants circulant à travers le premier transistor bipolaire (34, 34i) et le deuxième transistor bipolaire (36, 36i) similaires,
une résistance du deuxième transistor à effet de champ (32, 32i) entre son drain (D) et sa source (S) pendant une conduction étant supérieure à une résistance du premier transistor à effet de champ (22, 22i) entre son drain (S) et sa source (S) pendant une conduction, et une tension de drain du premier transistor à effet de champ (22, 22i) étant maintenue égale à une tension de drain du deuxième transistor à effet de champ (32, 32i) via une boucle de rétroaction formée par le premier transistor bipolaire (34, 34i), le deuxième transistor bipolaire (36, 36i) et l'amplificateur opérationnel (38, 38i).

2. Circuit de détection de courant (30) selon la revendication 1, **caractérisé en ce que**
le deuxième transistor à effet de champ (32i) est de type à canal N, le troisième transistor à effet de champ (40) et le quatrième transistor à effet de champ (42) sont de type à canal P et les premier et deuxième transistors bipolaires (34, 36) sont de type PNP,
une source du deuxième transistor à effet de champ (32) est mise à la terre,
des grilles du troisième transistor à effet de champ (40) et du quatrième transistor à effet de champ (42) sont connectées ensemble et connectées au collecteur du deuxième transistor bipolaire (36),
un drain et une source du troisième transistor à effet de champ (40) sont respectivement connectés à une première source d'alimentation (VDD) et au collecteur du premier transistor bipolaire (34), et
un drain et une source du quatrième transistor à effet de champ (42) sont respectivement connectés à la première source d'alimentation (VDD) et au collecteur du deuxième transistor bipolaire (36).

3. Circuit de détection de courant (30i) selon la revendication 1, **caractérisé en ce que**
le deuxième transistor à effet de champ (32i) est de type à canal P, le troisième transistor à effet de champ (40i) et le quatrième transistor à effet de champ (42i) sont de type à canal N et les premier et deuxième transistors bipolaires (34i, 36i) sont de type NPN,
une source du deuxième transistor à effet de champ (32i) est connectée à une deuxième source d'alimentation (UB),
des grilles du troisième transistor à effet de champ (40i) et du quatrième transistor à effet de champ (42i) sont connectées ensemble et connectées au collecteur du deuxième transistor bipolaire (36i),
une source et un drain du troisième transistor à effet de champ (40i) sont respectivement connectés à une troisième source d'alimentation (VT) et au collecteur du premier transistor bipolaire (34i), une tension de la troisième source d'alimentation (VT) est inférieure à une tension de la deuxième source d'alimentation (UB), et
une source et un drain du quatrième transistor à effet de champ (42i) sont respectivement connectés à la troisième source d'alimentation (VT) et au collecteur du deuxième transistor bipolaire (36i).

4. Circuit de détection de courant (30, 30i) selon la revendication 1, **caractérisé en ce qu'**il comprend en outre
un circuit de conversion (44, 44i) pour convertir le courant de détection en un signal de non-courant et le délivrer à un autre dispositif (46).

5. Circuit de détection de courant (30) selon la revendication 4, **caractérisé en ce que**
le deuxième transistor à effet de champ (32i) est de type à canal N, le troisième transistor à effet de champ (40) et le quatrième transistor à effet de champ (42) sont de type à canal P et les premier et deuxième transistors bipolaires (34, 36) sont de type PNP,
une source du deuxième transistor à effet de champ (32) est mise à la terre,
des grilles du troisième transistor à effet de champ (40) et du quatrième transistor à effet de champ (42) sont connectées ensemble et connectées au collecteur du deuxième transistor bipolaire (36),
un drain et une source du troisième transistor à effet de champ (40) sont respectivement connectés à une première source d'alimentation (VDD) et au collecteur du premier transistor bipolaire (34), et
un drain et une source du quatrième transistor à effet de champ (42) sont respectivement connectés à la première source d'alimentation (VDD) et au collecteur du deuxième transistor bipolaire (36).

6. Circuit de détection de courant (30) selon la revendication 5, **caractérisé en ce que**
le circuit de conversion (44) comprend un cinquième transistor à effet de champ (48) et une première résistance (50), la grille et le drain de cinquième transistor à effet de champ (48) sont respectivement connectés au collecteur du deuxième transistor bipolaire (36) et à la première source d'alimentation (VDD), et la première résistance (50) est connectée entre la source du cinquième transistor à effet de champ (48) et la terre, et
ledit autre dispositif (46) est connecté entre la source du cinquième transistor à effet de champ (48) et la première résistance (50).

7. Circuit de détection de courant (30i) selon la revendication 4, **caractérisé en ce que**
le deuxième transistor à effet de champ (32i) est de type à canal P, le troisième transistor à effet de champ (40i) et le quatrième transistor à effet de champ (42i) sont de type à canal N et les premier et deuxième transistors bipolaires (34i, 36i) sont de type NPN,
une source du deuxième transistor à effet de champ (32i) est connectée à une deuxième source d'alimentation (UB),
des grilles du troisième transistor à effet de champ (40i) et du quatrième transistor à effet de champ (42i) sont connectées ensemble et connectées au collecteur du deuxième transistor bipolaire (36i),
une source et un drain du troisième transistor à effet de champ (40i) sont respectivement connectés à une troisième source d'alimentation (VT) et au collecteur du premier transistor bipolaire (34i), une tension de la troisième source d'alimentation (VT) est inférieure à une tension de la deuxième source d'alimentation (UB), et
une source et un drain du quatrième transistor à effet de champ (42i) sont respectivement connectés à la troisième source d'alimentation (VT) et au collecteur du deuxième transistor bipolaire (36i).

8. Circuit de détection de courant (30i) selon la revendication 7, **caractérisé en ce que**,
le circuit de conversion (44i) comprend un sixième transistor à effet de champ (52), un septième transistor à effet de champ (54), un huitième transistor à effet de champ (56) et une deuxième résistance (50i),
une grille, une source et un drain du sixième transistor à effet de champ (52) sont respectivement connectés au drain du quatrième transistor à effet de champ (42i), à la troisième source d'alimentation (VT) et à un drain du septième transistor à effet de champ (54),
des sources du septième transistor à effet de champ (54) et du huitième transistor à effet de champ (56) sont connectées à la deuxième source d'alimentation (UB),
des grilles du septième transistor à effet de champ (54) et du huitième transistor à effet de champ (56) sont connectées ensemble et connectées au drain du septième transistor à effet de champ (54),
la deuxième résistance (50i) est connectée entre la grille du huitième transistor à effet de champ (56) et la troisième source d'alimentation (VT), et
ledit autre dispositif (46) est connecté entre la grille du huitième transistor à effet de champ (56) et la deuxième résistance (50i).

9. Circuit de détection de courant (30, 30i) selon la revendication 1, **caractérisé en ce qu'**il comprend en outre
un circuit filtre (210) connecté entre une entrée positive et une entrée négative de l'amplificateur opérationnel (38, 38i).

10. Circuit de détection de courant (30) selon la revendication 2 ou la revendication 5, **caractérisé en ce qu'**il comprend en outre :
un neuvième transistor à effet de champ (230) ayant sa grille et son drain respectivement connectés à la sortie de l'amplificateur opérationnel (38, 38i) et à la première source d'alimentation (VDD) ; et
une troisième résistance (230) connectée entre une source du neuvième transistor à effet de champ (230) et la terre,
les bases des premier et deuxième transistors bipolaires (34, 34i, 36, 36i) étant connectées entre la source du neuvième transistor à effet de champ (230) et la troisième résistance (230).

11. Circuit intégré (10, 200, 300), **caractérisé en ce qu'**il comprend en outre :
un circuit de travail (20, 20i) ayant un premier transistor à effet de champ (22, 22i) ; et
un circuit de détection de courant (30, 30i) selon l'une quelconque des revendications 1 à 10.
